# EUROPEAN PATENT APPLICATION

(11) **EP 4 766 097 A1**
(43) Date of publication of application: **24.06.2026**
(21) Application number: 25219295.0
(22) Date of filing: 28.11.2025
(51) Int. Cl.: H10F 10/165, H10F 71/00, H10F 77/20, H10F 77/30

(54) **TBC SOLAR CELL, BACKSIDE STRUCTURE OF TBC SOLAR CELL, AND PREPARING METHODS FOR TBC SOLAR CELL AND ITS BACKSIDE STRUCTURE**

(30) Priority: 20.12.2024 CN 202411889468
(71) Applicant: HUAI'AN JIETAI NEW ENERGY TECHNOLOGY CO., LTD., Huaian City, Jiangsu 223400 (CN)
(72) Inventor: ZHOU, Fushen, Huaian City, Jiangsu Province 223400 (CN); ZHANG, Manliang, Huaian City, Jiangsu Province 223400 (CN); FANG, Tao, Huaian City, Jiangsu Province 223400 (CN)
(74) Representative: karo IP

(57) **Abstract**

The present invention relates to the field of solar cell technologies, and discloses a TBC solar cell, a backside structure of TBC solar cell, and preparing methods for TBC solar cell and its backside structure. A high-concentration doped region (212a) and a low-concentration doped region (212b) are disposed in a first doped polysilicon layer (212) included in the backside structure of a TBC solar cell provided in the present invention, which ensures on the one hand that a metal electrode is in good contact with polysilicon, and on the other hand that the cell has low contact resistance, so that the conversion efficiency of the cell is high. In the backside structure of a TBC solar cell or the method for preparing a TBC solar cell provided in the present invention, while it is ensured that the thickness of the first doped polysilicon layer is not reduced, the low-concentration doped region is disposed to reduce an adverse impact of laser patterning on subsequent wet etching of polysilicon, thereby ensuring the effect of wet etching polysilicon. Therefore, while the performance of the cell is ensured, the complexity of the preparation process is reduced, and cell manufacturing yield is improved.

## Description

The present invention relates to the field of solar cell technologies, and in particular, to a TBC solar cell, a backside structure of TBC solar cell, and preparing methods for TBC solar cell and its backside structure.

A TOPCon solar cell, due to its unique structure, enables selective carrier transport, thereby reducing recombination, so that the open-circuit voltage and fill factor of the cell are improved, ultimately enhancing the conversion efficiency of the cell. Back contact of a BC(Back Contact) cell means that both the emitter electrode and the base electrode are located on the backside. In the structure of the back contact cell, on one hand, the emitter electrode is relocated to the backside of the cell, thereby reducing or eliminating shading losses from front grid lines and improving cell efficiency. A TBC (TOPCon+BC) cell structure adopts the TOPCon structures for both polarities (P-type and N-type) in its backsidebackside structure, and achieves high current while maintaining high open-circuit voltage and fill factor, thereby greatly improving cell efficiency.

In industrial production of TBC solar cells, P-type doped polysilicon is typically prepared first, and then N-type doped polysilicon is prepared. A P-type doped polysilicon layer needs to be removed before N-type doped polysilicon is prepared. Consequently, the removal of P-type doped polysilicon is one of the critical steps in the preparation of TBC solar cells. Currently, methods for removing a P-type doped polysilicon layer mainly include mask-assisted wet etching or laser-assisted wet etching, with the latter being more commonly used.

The removal of a P-type doped polysilicon layer in TBC solar cells is primarily affected by a doping concentration in polysilicon. In particular, laser processing increases a surface concentration in the P-type doped polysilicon layer, which in turn makes the etching of the polysilicon layer more challenging. Existing approaches to address this issue involve reducing the doping concentration, but lead to an increase in contact resistance, which is detrimental to enhancing cell efficiency. Alternatively, new laser equipment such as a femtosecond laser may be used. However, equipment costs are increased, which is not conducive to reducing manufacturing costs.

For another example, in Patent Application No. CN118610280A, the etching complexity of the P-type doped polysilicon layer is reduced by reducing the thickness of the P-type doped polysilicon layer. However, on the one hand, this solution causes a high contact resistance of contact between a metal electrode and a polysilicon layer, and on the other hand, metal paste may readily overfire through polysilicon, thereby damaging the structure, reducing cell efficiency, and resulting in low cell yield.

One of the objectives of the present invention is to provide a backside structure of a TBC solar cell and a TBC solar cell with the backside structure. A metal electrode provided on the backside structure of the TBC solar cell is in good contact with a polysilicon layer.

In addition, the present invention further provides a process for preparing a TBC solar cell. A low-concentration doped region is disposed on an outer surface of a polysilicon layer without reducing the thickness of the polysilicon layer, to reduce the etching complexity of the polysilicon layer and improve cell yield while satisfying that the metal electrode provided on the backside structure of a TBC solar cell is in good contact with the polysilicon layer.

The technical solutions used in the present invention to resolve the foregoing problems are specified with the features of the independent claims. Embodiments thereof are specified in the dependent claims.

The technical solutions used in the present invention to resolve the foregoing problems are as follows:
According to the objectives of the present invention, a first aspect of the present invention provides a backside structure of a TBC solar cell, where the backside structure includes a first emitter region, an isolation region, and a second emitter region that are located on the backside of a base silicon wafer;
the first emitter region includes a first tunneling oxide layer, a first doped polysilicon layer, a passivation layer, and a first metal electrode that are stacked on the backside of the base silicon wafer, and the first metal electrode is in contact with the first doped polysilicon layer through the passivation layer;
the second emitter region includes a second tunneling oxide layer, a second doped polysilicon layer, a passivation layer, and a second metal electrode that are stacked on the backside of the base silicon wafer, and the second metal electrode is in contact with the second doped polysilicon layer through the passivation layer;
the isolation region is disposed between the first emitter region and the second emitter region;
the first doped polysilicon layer includes a high-concentration doped region and a low-concentration doped region;
the doping concentration in the low-concentration doped region increases from N1 to N2 in terms of thickness in the direction toward the base silicon wafer, and the highest doping concentration N2 in the low-concentration doped region does not exceed the doping concentration in the high-concentration doped region; and
the high-concentration doped region is located on the side close to the backside of the base silicon wafer, and the first metal electrode penetrates the low-concentration doped region to make contact with the high-concentration doped region.

For the backside structure of a TBC solar cell in any implementation solution of the first aspect according to the objectives of the present invention, the doping concentration remains substantially the same at different positions of the high-concentration doped region.

For the backside structure of a TBC solar cell in any implementation solution of the first aspect according to the objectives of the present invention, the first doped polysilicon layer is a P-type doped polysilicon layer, and the second doped polysilicon layer is an N-type doped polysilicon layer.

For the backside structure of a TBC solar cell in any implementation solution of the first aspect according to the objectives of the present invention, the doping concentration N1 in the low-concentration doped region ranges from 1E19 atoms/cm³ to 4E19 atoms/cm³ (atoms/cm³ represents a doping concentration of 1×10¹⁹ atoms per cubic centimeter), and the doping concentration N2 in the low-concentration doped region ranges from 5E19 atoms/cm³ to 1E20 atoms/cm³.

For the backside structure of a TBC solar cell in any implementation solution of the first aspect according to the objectives of the present invention, N2/N1 ≥ 1.25, and preferably, 1.25 ≤ N2/N1 ≤ 10.

For the backside structure of a TBC solar cell in any implementation solution of the first aspect according to the objectives of the present invention, the doping concentration in the high-concentration doped region is substantially close to the doping concentration N2, and ranges from 5E19 atoms/cm³ to 1E20 atoms/cm³.

For the backside structure of a TBC solar cell in any implementation solution of the first aspect according to the objectives of the present invention, the thickness of the first doped polysilicon layer is D1, the thickness of the low-concentration doped region is D2, the thickness of the high-concentration doped region is D1-D2 (a difference between D1 and D2), 2 < D1/D2 < 10, and preferably, 3 < D1/D2 < 7.

For the backside structure of a TBC solar cell in any implementation solution of the first aspect according to the objectives of the present invention, the thickness of the first doped polysilicon layer is D1, and 50 nm ≤ D1 ≤ 400 nm.

For the backside structure of a TBC solar cell in any implementation solution of the first aspect according to the objectives of the present invention, the thickness of the low-concentration doped region is D2, and 10 nm < D2 < 150 nm.

For the backside structure of a TBC solar cell in any implementation solution of the first aspect according to the objectives of the present invention, the thickness of the second doped polysilicon layer ranges from 30 nm to 300 nm.

For the backside structure of a TBC solar cell in any implementation solution of the first aspect according to the objectives of the present invention, the doping concentration in the second doped polysilicon layer ranges from 1E20 atoms/cm³ to 1E21 atoms/cm³.

For the backside structure of a TBC solar cell in any implementation solution of the first aspect according to the objectives of the present invention, the thickness of the first tunneling oxide layer ranges from 0.5 nm to 2.5 nm.

For the backside structure of a TBC solar cell in any implementation solution of the first aspect according to the objectives of the present invention, the thickness of the second tunneling oxide layer ranges from 0.5 nm to 2.5 nm.

For the backside structure of a TBC solar cell in any implementation solution of the first aspect according to the objectives of the present invention, the thickness of the passivation layer ranges from 40 nm to 80 nm.

For the backside structure of a TBC solar cell in any implementation solution of the first aspect according to the objectives of the present invention, the thickness of the passivation layer in the first emitter region is less than the thickness of the passivation layer in the second emitter region.

For the backside structure of a TBC solar cell in any implementation solution of the first aspect according to the objectives of the present invention, the thickness of the passivation layer in the first emitter region ranges from 60 nm to 80 nm, and the thickness of the passivation layer in the second emitter region ranges from 65 nm to 85 nm.

For the backside structure of a TBC solar cell in any implementation solution of the first aspect according to the objectives of the present invention, the depth of the isolation region ranges from 0.05 µm to 3 µm.

For the backside structure of a TBC solar cell in any implementation solution of the first aspect according to the objectives of the present invention, the grain size in the low-concentration doped region is smaller than the grain size in the high-concentration doped region.

For the backside structure of a TBC solar cell in any implementation solution of the first aspect according to the objectives of the present invention, the crystallinity in the low-concentration doped region is less than the crystallinity in the high-concentration doped region.

For the backside structure of a TBC solar cell in any implementation solution of the first aspect according to the objectives of the present invention, the crystallinity in the low-concentration doped region is less than 80%, and the crystallinity in the high-concentration doped region is greater than 80%.

For the backside structure of a TBC solar cell in any implementation solution of the first aspect according to the objectives of the present invention, the passivation layer includes any one or two of an oxide and a silicide.

For the backside structure of a TBC solar cell in any implementation solution of the first aspect according to the objectives of the present invention, the passivation layer includes one or a combination of aluminum oxide, silicon nitride, silicon oxide, and silicon oxynitride.

According to the objectives of the present invention, a second aspect of the present invention provides a method for preparing the backside structure of a TBC solar cell according to any implementation solution of the first aspect of the present invention, including:
Step S1: polishing a surface of a base silicon wafer;
Step S2: first depositing a tunneling oxide layer and then depositing a polysilicon layer on the processed surface in step S1, where
the depositing a polysilicon layer includes stage I and stage II, a deposition temperature in stage I is greater than a deposition temperature in stage II, and/or
a deposition pressure in stage I is less than a deposition pressure in stage II;
Step S3: performing doping using thermal diffusion to form a first doped polysilicon layer with a doped oxide layer;
Step S4: removing the doped oxide layer in a specific region using laser processing or etching to expose the polysilicon layer;
Step S5: performing alkaline polishing to remove the exposed polysilicon layer in step S4;
Step S6: depositing a tunneling oxide layer and a polysilicon layer on a surface of the processed specific region in step S5;
Step S7: performing doping using thermal diffusion to form a second doped polysilicon layer with a doped oxide layer in the specific region;
Step S8: removing a doped oxide in a region of the first doped polysilicon layer and a doped oxide in a region of the second doped polysilicon layer using laser processing or etching;
Step S9: removing second doped polysilicon layer in a region in which the first doped polysilicon layer is located on a backside of the base silicon wafer, and forming a groove between the region where the first doped polysilicon layer is located and a region where the second doped polysilicon layer is located;
Step S10: depositing a passivation layer on the backside of the base silicon wafer; and
Step S11: performing printing and sintering on the backside of the base silicon wafer to form a first metal electrode and a second metal electrode.

For the method for preparing the backside structure of a TBC solar cell in any implementation solution of the second aspect according to the objectives of the present invention, in step S2, the depositing a polysilicon layer on the surface includes stage I and stage II;
the deposition temperature in stage I ranges from 580°C to 600°C; and
the deposition temperature in stage II ranges from 550°C to 580°C.

For the method for preparing the backside structure of a TBC solar cell in any implementation solution of the second aspect according to the objectives of the present invention, in step S2, the depositing a polysilicon layer on the surface includes stage I and stage II;
the deposition pressure in stage I ranges from 150 mTorr to 250 mTorr (representing a pressure in micrometers of mercury); and
the deposition pressure in stage II ranges from 200 mTorr to 400 mTorr.

For the method for preparing the backside structure of a TBC solar cell in any implementation solution of the second aspect according to the objectives of the present invention, in step S2, the depositing a polysilicon layer on the surface includes stage I and stage II;
the deposition temperature in stage I ranges from 580°C to 600°C; and
the deposition temperature in stage II ranges from 550°C to 580°C; simultaneously,
the deposition pressure in stage I ranges from 150 mTorr to 250 mTorr; and
the deposition pressure in stage II ranges from 200 mTorr to 400 mTorr.

For the method for preparing the backside structure of a TBC solar cell in any implementation solution of the second aspect according to the objectives of the present invention, in step S2, during the deposition in stage I, the deposition temperature is kept constant;
during the deposition in stage II, the deposition temperature gradually decreases from 580°C to 550°C; and
preferably, during the deposition in stage II, the deposition temperature uniformly decreases from 580°C to 550°C.

For the method for preparing the backside structure of a TBC solar cell in any implementation solution of the second aspect according to the objectives of the present invention, in step S2, during the deposition in stage I, the deposition pressure is kept constant;
during the deposition in stage II, the deposition pressure is constant or gradually increases; and
preferably, during the deposition in stage II, the deposition pressure is constant, and is greater than the deposition pressure in stage I.

For the method for preparing the backside structure of a TBC solar cell in any implementation solution of the second aspect according to the objectives of the present invention, in step S2, the deposition temperature in stage I ranges from 580°C to 600°C;
the deposition temperature in stage II ranges from 550°C to 580°C;
simultaneously, during the deposition in stage I, the deposition temperature is kept constant;
during the deposition in stage II, the deposition temperature gradually decreases from 580°C to 550°C; and
preferably, during the deposition in stage II, the deposition temperature uniformly decreases from 580°C to 550°C.

For the method for preparing the backside structure of a TBC solar cell in any implementation solution of the second aspect according to the objectives of the present invention, in step S2, the deposition pressure in stage I ranges from 150 mTorr to 250 mTorr; and
the deposition pressure in stage II ranges from 200 mTorr to 400 mTorr;
simultaneously,
during the deposition in stage I, the deposition pressure is kept constant;
during the deposition in stage II, the deposition pressure is constant or gradually increases; and
preferably, during the deposition in stage II, the deposition pressure is constant, and is greater than the deposition pressure in stage I.

For the method for preparing the backside structure of a TBC solar cell in any implementation solution of the second aspect according to the objectives of the present invention, in step S1, the surface of the base silicon wafer is polished to form a textured pattern, the depth of the textured pattern is greater than 20 µm, and preferably, the depth ranges from 20 µm to 30 µm.

For the method for preparing the backside structure of a TBC solar cell in any implementation solution of the second aspect according to the objectives of the present invention, in step S2, the deposition temperature of the tunneling oxide layer ranges from 590°C to 650°C.

For the method for preparing the backside structure of a TBC solar cell in any implementation solution of the second aspect according to the objectives of the present invention, in step S2, the thickness of the tunneling oxide layer ranges from 0.5 nm to 2.5 nm.

For the method for preparing the backside structure of a TBC solar cell in any implementation solution of the second aspect according to the objectives of the present invention, in step S2, the thickness of the polysilicon layer ranges from 50 nm to 400 nm.

For the method for preparing the backside structure of a TBC solar cell in any implementation solution of the second aspect according to the objectives of the present invention, in step S2, the deposition thickness in stage II ranges from 10 nm to 150 nm; and
the deposition thickness in stage I is obtained by subtracting the deposition thickness in stage II from the thickness of the polysilicon layer.

For the method for preparing the backside structure of a TBC solar cell in any implementation solution of the second aspect according to the objectives of the present invention, in step S2, the thickness of the polysilicon layer is D1, the deposition thickness in stage II is D2, the deposition thickness in stage I is D1-D2, 2 < D1/D2 < 10, and preferably 3 < D1/D2 < 7.

For the method for preparing the backside structure of a TBC solar cell in any implementation solution of the second aspect according to the objectives of the present invention, in step S3, the diffusion is boron diffusion, the doped oxide layer is a borosilicate glass layer (BSG for short below), and the thickness of the doped oxide layer ranges from 40 nm to 60 nm.

For the method for preparing the backside structure of a TBC solar cell in any implementation solution of the second aspect according to the objectives of the present invention, in step S3, the surface concentration in the polysilicon layer is less than 4E19, preferably, ranges from 1E19 atoms/cm³ to 4E19 atoms/cm³.

For the method for preparing the backside structure of a TBC solar cell in any implementation solution of the second aspect according to the objectives of the present invention, in step S3, the concentration in the polysilicon layer formed in stage I ranges from 5E19 atoms/cm³ to 1E20 atoms/cm³;
the surface concentration N1 in the polysilicon layer formed in stage II is less than 4E19 atoms/cm³, and preferably, ranges from 1E19 atoms/cm³ to 4E19 atoms/cm³;
the doping concentration in the low-concentration doped region increases from N1 to N2 along the thickness toward the base silicon wafer, and the doping concentration N2 in the polysilicon layer formed in stage II does not exceed the concentration in the polysilicon layer formed in stage I; and
preferably, the doping concentration N2 in the polysilicon layer formed in stage II is close to or equal to the concentration in the polysilicon layer formed in stage I.

For the method for preparing the backside structure of a TBC solar cell in any implementation solution of the second aspect according to the objectives of the present invention, in step S5, the alkaline polishing is performed to remove the exposed polysilicon layer in step S4 to form a polished topography, and a region from which BSG is not removed is kept to form a height difference (GAP), GAP ranges from 0.1 µm to 0.3 µm, and the remaining thickness of BSG in the region with BSG unremoved ranges from 10 nm to 30 nm.

For the method for preparing the backside structure of a TBC solar cell in any implementation solution of the second aspect according to the objectives of the present invention, in step S6, the deposition temperature of the tunneling oxide layer ranges from 590°C to 650°C.

For the method for preparing the backside structure of a TBC solar cell in any implementation solution of the second aspect according to the objectives of the present invention, in step S6, the deposition thickness of the tunneling oxide layer ranges from 0.5 nm to 2.5 nm.

For the method for preparing the backside structure of a TBC solar cell in any implementation solution of the second aspect according to the objectives of the present invention, in step S6, the deposition temperature of the polysilicon layer ranges from 590°C to 630°C.

For the method for preparing the backside structure of a TBC solar cell in any implementation solution of the second aspect according to the objectives of the present invention, in step S6, the deposition thickness of the polysilicon layer ranges from 30 nm to 300 nm.

For the method for preparing the backside structure of a TBC solar cell in any implementation solution of the second aspect according to the objectives of the present invention, in step S7, the diffusion is phosphor diffusion, the doped oxide layer is a phosphosilicate glass layer (PSG for short below), and the thickness of the doped oxide layer ranges from 40 nm to 60 nm.

For the method for preparing the backside structure of a TBC solar cell in any implementation solution of the second aspect according to the objectives of the present invention, in step S9, the position of the groove substantially corresponds to the position of the isolation region.

For the method for preparing the backside structure of a TBC solar cell in any implementation solution of the second aspect according to the objectives of the present invention, in step S10, the thickness of the passivation layer ranges from 40 nm to 80 nm.

According to the objectives of the present invention, a third aspect of the present invention provides a TBC solar cell, where the cell includes:
a base silicon wafer, the base silicon wafer including a backside and a front side;
a backside structure disposed on the backside of the base silicon wafer, where the backside structure is the backside structure of a TBC solar cell according to any implementation solution of the first aspect, or is a backside structure of a TBC solar cell prepared using the method according to any implementation solution of the second aspect; and
a passivation layer disposed on the front side of the base silicon wafer.

For the TBC solar cell in any implementation solution of the third aspect according to the objectives of the present invention, the thickness of the passivation layer ranges from 50 nm to 100 nm.

For the TBC solar cell in any implementation solution of the third aspect according to the objectives of the present invention, the passivation layer includes any one or two of an oxide and a silicide.

For the TBC solar cell in any implementation solution of the third aspect according to the objectives of the present invention, the passivation layer includes one or a combination of aluminum oxide, silicon nitride, silicon oxide, and silicon oxynitride.

For the TBC solar cell in any implementation solution of the third aspect according to the objectives of the present invention, the thickness of the passivation layer ranges from 50 nm to 100 nm.

According to the objectives of the present invention, a fourth aspect of the present invention provides a method for preparing the TBC solar cell according to any implementation solution of the third aspect of the present invention, including:
Step A1: polishing a surface of a base silicon wafer;
Step A2: first depositing a tunneling oxide layer and then depositing a polysilicon layer on the processed surface in step A1, where
the depositing a polysilicon layer includes stage I and stage II, a deposition temperature in stage I is greater than a deposition temperature in stage II, and/or
a deposition pressure in stage I is less than a deposition pressure in stage II;
Step A3: performing doping using thermal diffusion to form a first doped polysilicon layer with a doped oxide layer;
Step A4: removing the doped oxide layer in a specific region using laser processing or etching to expose the polysilicon layer;
Step A5: performing alkaline polishing to remove the exposed polysilicon layer in step A4;
Step A6: depositing a tunneling oxide layer and a polysilicon layer on a surface of the processed specific region in step A5;
Step A7: performing doping using thermal diffusion to form a second doped polysilicon layer with a doped oxide layer in the specific region;
Step A8: removing a doped oxide in a region of the first doped polysilicon layer and a doped oxide in a region of the second doped polysilicon layer using laser processing or etching;
Step A9: etching and texturing a front side of the base silicon wafer;
removing second doped polysilicon layer in a region in which the first doped polysilicon layer is located on a backside of the base silicon wafer, and forming a groove between the region in which the first doped polysilicon layer is located and a region in which the second doped polysilicon layer is located;
Step A10: depositing a passivation layer on the front side and the backside of the base silicon wafer; and
Step A11: performing printing and sintering on the backside of the base silicon wafer to form a first metal electrode and a second metal electrode.

For the method for preparing the TBC solar cell in any implementation solution of the fourth aspect according to the objectives of the present invention, in step A2, the depositing a polysilicon layer on the surface includes stage I and stage II;
the deposition temperature in stage I ranges from 580°C to 600°C; and
the deposition temperature in stage II ranges from 550°C to 580°C.

For the method for preparing the TBC solar cell in any implementation solution of the fourth aspect according to the objectives of the present invention, in step A2, the depositing a polysilicon layer on the surface includes stage I and stage II;
the deposition pressure in stage I ranges from 150 mTorr to 250 mTorr; and
the deposition pressure in stage II ranges from 200 mTorr to 400 mTorr.

For the method for preparing the TBC solar cell in any implementation solution of the fourth aspect according to the objectives of the present invention, in step A2, the depositing a polysilicon layer on the surface includes stage I and stage II;
the deposition temperature in stage I ranges from 580°C to 600°C; and
the deposition temperature in stage II ranges from 550°C to 580°C;
simultaneously,
the deposition pressure in stage I ranges from 150 mTorr to 250 mTorr; and
the deposition pressure in stage II ranges from 200 mTorr to 400 mTorr.

For the method for preparing the TBC solar cell in any implementation solution of the fourth aspect according to the objectives of the present invention, in step A2, during the deposition in stage I, the deposition temperature is kept constant;
during the deposition in stage II, the deposition temperature gradually decreases from 580°C to 550°C; and
preferably, during the deposition in stage II, the deposition temperature uniformly decreases from 580°C to 550°C.

For the method for preparing the TBC solar cell in any implementation solution of the fourth aspect according to the objectives of the present invention, in step A2, during the deposition in stage I, the deposition pressure is kept constant;
during the deposition in stage II, the deposition pressure is constant or gradually increases; and
preferably, during the deposition in stage II, the deposition pressure is constant, and is greater than the deposition pressure in stage I.

For the method for preparing the TBC solar cell in any implementation solution of the fourth aspect according to the objectives of the present invention, in step A2, the deposition temperature in stage I ranges from 580°C to 600°C;
the deposition temperature in stage II ranges from 550°C to 580°C;
simultaneously, during the deposition in stage I, the deposition temperature is kept constant;
during the deposition in stage II, the deposition temperature gradually decreases from 580°C to 550°C; and
preferably, during the deposition in stage II, the deposition temperature uniformly decreases from 580°C to 550°C.

For the method for preparing the TBC solar cell in any implementation solution of the fourth aspect according to the objectives of the present invention, in step A2, the deposition pressure in stage I ranges from 150 mTorr to 250 mTorr;
the deposition pressure in stage II ranges from 200 mTorr to 400 mTorr;
simultaneously,
during the deposition in stage I, the deposition pressure is kept constant;
during the deposition in stage II, the deposition pressure is constant or gradually increases; and
preferably, during the deposition in stage II, the deposition pressure is constant, and is greater than the deposition pressure in stage I.

For the method for preparing the TBC solar cell in any implementation solution of the fourth aspect according to the objectives of the present invention, in step A1, the surface of the base silicon wafer is polished to form a textured pattern, the depth of the textured pattern is greater than 20 µm, and preferably, the depth ranges from 20 µm to 30 µm.

For the method for preparing the TBC solar cell in any implementation solution of the fourth aspect according to the objectives of the present invention, in step A2, the deposition temperature of the tunneling oxide layer ranges from 590°C to 650°C.

For the method for preparing the TBC solar cell in any implementation solution of the fourth aspect according to the objectives of the present invention, in step A2, the thickness of the tunneling oxide layer ranges from 0.5 nm to 2.5 nm.

For the method for preparing the TBC solar cell in any implementation solution of the fourth aspect according to the objectives of the present invention, in step A2, the thickness of the polysilicon layer ranges from 50 nm to 400 nm.

For the method for preparing the TBC solar cell in any implementation solution of the fourth aspect according to the objectives of the present invention, in step A2, the deposition thickness in stage II ranges from 10 nm to 150 nm; and
the deposition thickness in stage I is obtained by subtracting the deposition thickness in stage II from the thickness of the polysilicon layer.

For the method for preparing the TBC solar cell in any implementation solution of the fourth aspect according to the objectives of the present invention, in step A2, the thickness of the polysilicon layer is D1, the deposition thickness in stage II is D2, the deposition thickness in stage I is D1-D2, 2 < D1/D2 < 10, and preferably 3 < D1/D2 < 7.

For the method for preparing the TBC solar cell in any implementation solution of the fourth aspect according to the objectives of the present invention, in step A3, the diffusion is boron diffusion, the doped oxide layer is a borosilicate glass layer (BSG for short below), and the thickness of the doped oxide layer ranges from 40 nm to 60 nm.

For the method for preparing the TBC solar cell in any implementation solution of the fourth aspect according to the objectives of the present invention, in step A3, the surface concentration in the polysilicon layer is less than 4E19, preferably, ranges from 1E19 atoms/cm³ to 4E19 atoms/cm³.

For the method for preparing the TBC solar cell in any implementation solution of the fourth aspect according to the objectives of the present invention, in step A3, the concentration in the polysilicon layer formed in stage I ranges from 5E19 atoms/cm³ to 1E20 atoms/cm³;
the surface concentration N1 in the polysilicon layer formed in stage II is less than 4E19 atoms/cm³, and preferably, ranges from 1E19 atoms/cm³ to 4E19 atoms/cm³;
the doping concentration in the low-concentration doped region increases from N1 to N2 along a thickness toward the base silicon wafer, and the doping concentration N2 in the polysilicon layer formed in stage II does not exceed the concentration in the polysilicon layer formed in stage I; and
preferably, the doping concentration N2 in the polysilicon layer formed in stage II is close to or equal to the concentration in the polysilicon layer formed in stage I.

For the method for preparing the TBC solar cell in any implementation solution of the fourth aspect according to the objectives of the present invention, in step A5, the alkaline polishing is performed to remove the exposed polysilicon layer in step A4 to form a polished topography, and a region from which BSG is not removed is kept to form a height difference (GAP), GAP ranges from 0.1 µm to 0.3 µm, and the remaining thickness of BSG in the region with BSG unremoved ranges from 10 nm to 30 nm.

For the method for preparing the TBC solar cell in any implementation solution of the fourth aspect according to the objectives of the present invention, in step A6, the deposition temperature of the tunneling oxide layer ranges from 590°C to 650°C.

For the method for preparing the TBC solar cell in any implementation solution of the fourth aspect according to the objectives of the present invention, in step A6, the deposition thickness of the tunneling oxide layer ranges from 0.5 nm to 2.5 nm.

For the method for preparing the TBC solar cell in any implementation solution of the fourth aspect according to the objectives of the present invention, in step A6, the deposition temperature of the polysilicon layer ranges from 590°C to 630°C.

For the method for preparing the TBC solar cell in any implementation solution of the fourth aspect according to the objectives of the present invention, in step A6, the deposition thickness of the polysilicon layer ranges from 30 nm to 300 nm.

For the method for preparing the TBC solar cell in any implementation solution of the fourth aspect according to the objectives of the present invention, in step A7, the diffusion is phosphor diffusion, the doped oxide layer is a phosphosilicate glass layer (PSG for short below), and the thickness of the doped oxide layer ranges from 40 nm to 60 nm.

For the method for preparing the TBC solar cell in any implementation solution of the fourth aspect according to the objectives of the present invention, in step A9, the position of the groove substantially corresponds to the position of the isolation region.

For the method for preparing the TBC solar cell in any implementation solution of the fourth aspect according to the objectives of the present invention, in step A10, the thickness of the passivation layer ranges from 40 nm to 80 nm.

The proposed subject-matter may include one or more of the following beneficial effects:
(1) A high-concentration doped region and a low-concentration doped region are disposed in a first doped polysilicon layer included in the backside structure of a TBC solar cell or the TBC solar cell with a backside structure provided in the present invention, which ensures on one hand that a metal electrode is in good contact with polysilicon, and on the other hand that the cell has low contact resistance, so that the conversion efficiency of the cell is high.
(2) The removal of a first doped polysilicon layer in TBC solar cells is primarily affected by a doping concentration in polysilicon. In particular, laser processing affects a polysilicon layer, making subsequent wet etching of polysilicon more challenging. To resolve the problem, the first processing method is to reduce the doping concentration in the first doped polysilicon layer. The method causes an increase in the contact resistance between the metal electrode and polysilicon, which is detrimental to cell efficiency. The second processing method is to reduce the thickness of the first doped polysilicon layer. This method also causes an increase in the contact resistance between the metal electrode and polysilicon, and in addition increases the risk that metal paste overfires through polysilicon, resulting in damage to the structure and reduced cell yield and efficiency. The third processing method is to use new laser equipment such as a femtosecond laser. However, equipment costs are increased, which is not conducive to reducing manufacturing costs.

In this context, in the backside structure of a TBC solar cell or the method for preparing a TBC solar cell provided in the present invention, while it is ensured that the thickness of the first doped polysilicon layer is not reduced, the low-concentration doped region is disposed to reduce an adverse impact of laser patterning on subsequent wet etching of polysilicon, thereby ensuring the effect of wet etching polysilicon. Therefore, while the performance of the cell is ensured, the complexity of the preparation process is reduced, and cell manufacturing yield is improved.
(3) For the backside structure of a TBC solar cell or the method for preparing the TBC solar cell provided in the present invention, it is required that the low doping concentration N1 in the low-concentration doped region should range from 1E19 atoms/cm³ to 4E19 atoms/cm³, it is also required that the highest doping concentration N2 in the low-concentration doped region should not exceed the doping concentration in the high-concentration doped region, and it is required that the highest doping concentration N2 in the low-concentration doped region should range from 5E19 atoms/cm³ to 1E20 atoms/cm³.

It can be further ensured that an adverse impact of laser patterning on subsequent wet etching of polysilicon is reduced, thereby ensuring the effect of wet etching polysilicon. Therefore, while the performance of the cell is ensured, the complexity of the preparation process is reduced, and a cell manufacturing yield is improved.
(4) Based on the foregoing doping concentration requirements of the low-concentration doped region and the high-concentration doped region, it is further required that a ratio of the thickness (D2) of the low-concentration doped region to the thickness (D1) of the first doped polysilicon layer satisfies 2 < D1/D2 < 7. In this way, an adverse impact of laser patterning on subsequent wet etching of polysilicon can be reduced, thereby ensuring the effect of wet etching of polysilicon, and an adverse impact on contact resistance between the metal electrode and polysilicon can be avoided.

The proposed subject-matter and the technical field is further explained with the accompanied drawings, wherein
FIG. 1 is a schematic diagram of a TBC solar cell and a backside structure the TBC solar cell in Comparative Example 1 (an existing technology);
FIG. 2 is a schematic diagram of a backside structure (B-TBC-1) of a TBC solar cell according to Embodiment 1 of the present invention;
FIG. 3 is a schematic enlarged view of a local region C in the backside structure of a TBC solar cell in FIG. 2;
FIG. 4 is a schematic structural diagram of a TBC solar cell of B-TBC-1 according to an embodiment of the present invention;
FIG. 5 is a doping curve in a first doped polysilicon layer (that is, P-type polysilicon) according to Embodiment 1 of the present invention; and
FIG. 6 is doping curves in a first doped polysilicon layer (that is, P-type polysilicon) according to Embodiment 1 and Comparative Examples 1 and 2 of the present invention.

In the figure: 1. base silicon wafer;
100. front side of the base silicon wafer; 110. third passivation layer;
200. backside of the base silicon wafer; 210. first emitter region; 211. first tunneling oxide layer; 212. first doped polysilicon layer; 212a. high-concentration doped region; 212b. low-concentration doped region; 213. first metal electrode; 214. first passivation layer; 220. second emitter region; 221. second tunneling oxide layer; 222. second doped polysilicon layer; 223. second metal electrode; 224. second passivation layer; and 230. isolation region;
A. thickness direction of the first doped polysilicon layer;
C. local region;
D1. thickness of the first doped polysilicon layer;
D2. thickness of the low-concentration doped region;
D1-D2. thickness of the high-concentration doped region;
N1. doping concentration at the starting point of the low-concentration doped region;
N2. doping concentration at the starting point of the high-concentration doped region (which is also the highest doping concentration in the low-concentration doped region); and
∠A. angle between a connection line between the starting point of a low-concentration doped region and the starting point of the high-concentration doped region and a horizontal line of a starting concentration in the high-concentration doped region.

The present disclosure may be more easily understood with reference to the following description in conjunction with the accompanying drawings and examples, all of which form part of the present disclosure. It is to be understood that the present disclosure is not limited to the specific products, methods, conditions, or parameters described and/or shown herein. Furthermore, the terminology used herein is for the purpose of describing particular embodiments by way of example only and is not intended to be limiting, unless otherwise specified.

It should be further understood that, for clarity, certain features of the present disclosure may be described herein in the context of separate embodiments, but may also be provided in combination with each other in a single embodiment. That is, unless clearly incompatible or specifically excluded, each individual embodiment is considered combinable with any other embodiment, and such a combination is considered to represent another distinct embodiment. Conversely, for brevity, various features of the present disclosure that are described in the context of a single embodiment may also be provided separately or in any subcombination. Finally, although specific embodiments may be described as part of a series of steps or as part of a more general structure, each step or substructure may itself be considered an independent embodiment.

Unless otherwise specified, it should be understood that each individual element in a list and each combination of individual elements in the list shall be construed as distinct embodiments. For example, a list of embodiments expressed as "A, B, or C" shall be interpreted to include embodiments "A", "B", "C", "A or B", "A or C", "B or C", or "A, B, or C".

In the present disclosure, the singular forms of articles "a", "an", and "the" also include a plurality of corresponding referents, and reference to a specific value includes at least the specific value, unless the context clearly dictates otherwise. Therefore, for example, reference to "a substance" is reference to at least one of such substance and equivalents thereof.

Terms including ordinals such as "first" and "second" may be used to describe various components or fluids, but these components or fluids are not limited by these terms. Therefore, these terms are used only to distinguish one component/fluid from another component/fluid without departing from the teachings of the present disclosure.

When items are described using conjunctive terms such as "... and/or ...", the description shall be understood as including any one of the associated listed items and all combinations of one or more thereof. For example, "A and/or B" shall be interpreted as encompassing an embodiment including "A" but excluding "B", an embodiment including "B" but excluding "A", and an embodiment including both "A" and "B".

Throughout the specification of this application document, when a part is described as "including" a component, unless otherwise explicitly stated to the contrary, it does not mean that another component is excluded, but rather indicates that another component may also be included.

Unless otherwise defined, all technical and scientific terms used in this specification have the same meanings as those generally understood by a person skilled in the art to which the present invention belongs. The term "and/or" used in this specification includes any and all combinations of one or more related listed items. To clarify the technical solutions and advantages of the present invention, the following completely describes the technical solutions in the embodiments of the present invention.

### Embodiment 1

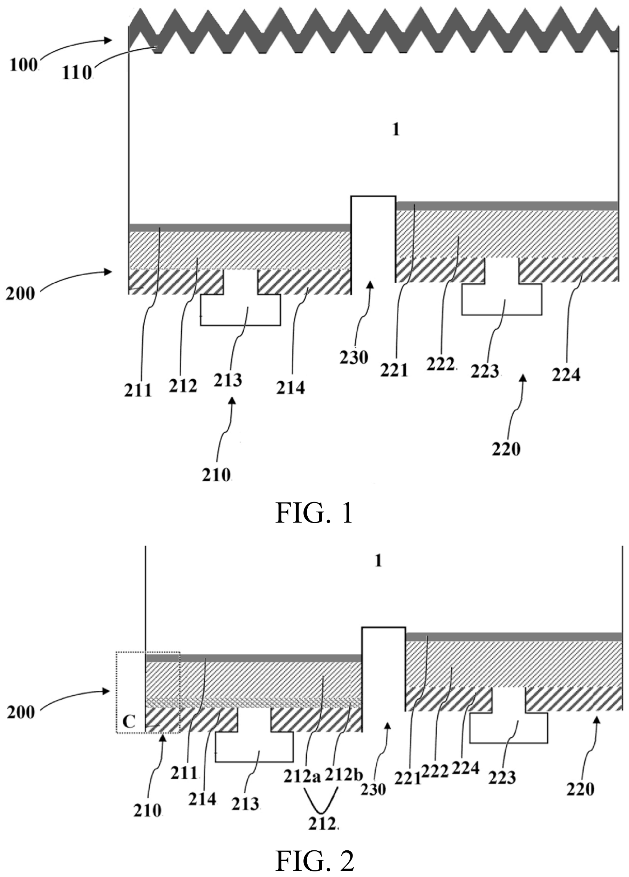

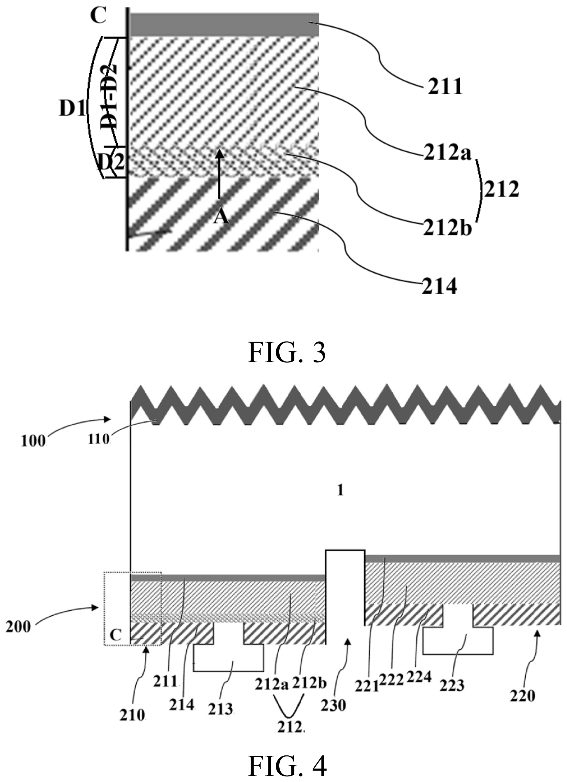

As shown in FIG. 2 and FIG. 3, this embodiment provides a backside structure (B-TBC-1) of a TBC solar cell. For ease of description, only a part related to the embodiments of the present invention is shown, referring to FIG. 2 and FIG. 3.

The backside structure of a TBC solar cell provided in the embodiments of the present invention includes:
a base silicon wafer 1, a first emitter region 210 and a second emitter region 220 that are disposed on a backside 200 of the base silicon wafer, and an isolation region 230 that has a depth ranging from 0.05 µm to 3 µm and a width ranging from 10 µm to 100 µm and that is disposed between the first emitter region 210 and the second emitter region 220.

As shown in FIG. 2, the first emitter region 210 includes a first tunneling oxide layer 211, a first doped polysilicon layer 212, a first passivation layer 214, and a first metal electrode 213 that are stacked on the backside 200 of the base silicon wafer. The first metal electrode 213 is in contact with first doped polysilicon layer 212 penetrating the first passivation layer 214. The first doped polysilicon layer 212 includes a high-concentration doped region 212a stacked on the first tunneling oxide layer 211 and a low-concentration doped region 212b stacked on the high-concentration doped region 212a. The first metal electrode 213 is in contact with the high-concentration doped region 212a penetrating the low-concentration doped region 212b, but is not in contact with the first tunneling oxide layer 211.

The second emitter region 220 includes a second tunneling oxide layer 221, a second doped polysilicon layer 222, a second passivation layer 224, and a second metal electrode 223 that are stacked on the backside 200 of the base silicon wafer. The second metal electrode 223 is in contact with the second doped polysilicon layer 222 penetrating the second passivation layer 224.

Currently, the first tunneling oxide layer 211 and the second tunneling oxide layer 221 are mainly formed using thermal oxidation (including dry oxidation and wet oxidation), a chemical vapor deposition (CVD) (including plasma-enhanced chemical vapor deposition (PECVD), low-pressure chemical vapor deposition (LPCVD)), room-temperature wet oxidation, and the like. Preferably, low-pressure chemical vapor deposition (LPCVD) is used. In some embodiments of the present invention, a thickness of the first tunneling oxide layer 211 ranges from 0.5 nm to 2.5 nm, and a thickness of the second tunneling oxide layer 221 ranges from 0.5 nm to 2.5 nm. For the specific backside structure B-TBC-1 of a TBC solar cell provided in this specific embodiment, the depth of the isolation region 230 is 2.5 µm, the width of the isolation region 230 is 40 µm, the thickness of the first tunneling oxide layer 211 is 1.8 nm, and the thickness of the second tunneling oxide layer 221 is 1.5 nm.

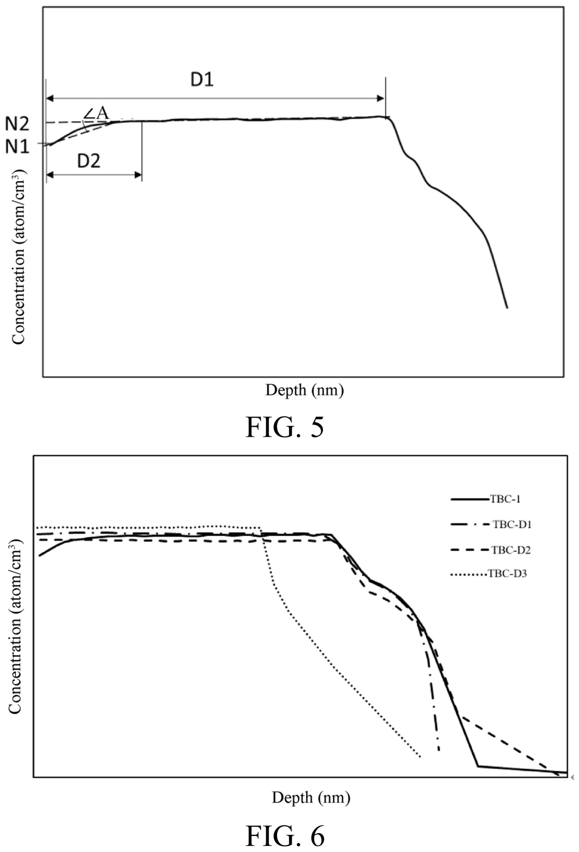

The first doped polysilicon layer 212 is a "doped polysilicon layer" containing a first doped element. The second doped polysilicon layer 222 is a "doped polysilicon layer" containing a second doped element. The first doped element is different from the second doped element. The "doped polysilicon layers" are formed using several methods. For example, a doped polysilicon layer is directly deposited using LPCVD. The deposition and doping of a polysilicon layer can be completed in one step using this method. Alternatively, an intrinsic polysilicon layer may be first deposited using PECVD or LPCVD, and doping is then performed using ion implantation, diffusion, or another process. Various doping methods yield little difference in process effects. In some embodiments of the present invention, the first doped polysilicon layer 212 is P-type doped, and a thickness D1 of the first doped polysilicon layer 212 ranges from 50 nm to 400 nm. Based on this, a thickness D2 of the low-concentration doped region 212b satisfies 10 nm < D2 < 150 nm. A thickness of the high-concentration doped region 212a is D1-D2. In terms of concentration, a doping concentration in the high-concentration doped region 212a ranges from 5E19 atoms/cm³ to 1E20 atoms/cm³. In a direction A (toward the base silicon wafer) shown in FIG. 3, a doping concentration in the low-concentration doped region increases from N1 to N2 along a thickness, and the doping concentration N1 in the low-concentration doped region ranges from 1E19 atoms/cm³ to 4E19 atoms/cm³. The highest doping concentration N2 in the low-concentration doped region does not exceed the doping concentration in the high-concentration doped region. Preferably, the highest doping concentration N2 in the low-concentration doped region and the doping concentration in the high-concentration doped region 212a are the same, ranging from 5E19 atoms/cm³ to 1E20 atoms/cm³. In some embodiments of the present invention, the second doped polysilicon layer 222 is N-type doped, and a thickness D3 of the second doped polysilicon layer 222 ranges from 30 nm to 300 nm. Based on this, a doping concentration in the second doped polysilicon layer 222 ranges from 1E20 atoms/cm³ to 1E21 atoms/cm³. In some preferred embodiments of the present invention, 2 < D1/D2 < 7. In some preferred embodiments of the present invention, N2/N1 ≥ 1.25. In some preferred embodiments of the present invention, 1.25 ≤ N2/N1 ≤ 10. Referring to FIG. 5, for the specific backside structure B-TBC-1 of a TBC solar cell provided in this specific embodiment, the first doped polysilicon layer 212 is P-type doped, and the thickness D1 of the first doped polysilicon layer 212 is 350 nm. The thickness D2 of the low-concentration doped region 212b is 100 nm. The thickness of the high-concentration doped region 212a is D1-D2. In terms of concentration, the doping concentration in the high-concentration doped region 212a is 6E19 atoms/cm³, and ∠A in FIG. 5 is an angle between a connection line between the starting point of a low-concentration doped region and the starting point of the high-concentration doped region and a horizontal line of a starting concentration in the high-concentration doped region. In the direction A (toward the base silicon wafer) shown in FIG. 3, the doping concentration in the low-concentration doped region 212b increases from N1 to N2 along the thickness. The doping concentration N1 in the low-concentration doped region 212b is 2E19 atoms/cm³. The highest doping concentration N2 in the low-concentration doped region 212b is the same as the doping concentration in the high-concentration doped region 212a. The second doped polysilicon layer 222 is N-type doped. The thickness D3 of the second doped polysilicon layer 222 is 200 nm. The doping concentration in the second doped polysilicon layer 222 is 6E20 atoms/cm³.

Each of the first passivation layer 214 and the second passivation layer 224 includes one or a combination of an oxide layer (for example, a silicon oxide layer or an aluminum oxide layer (AlOₓ layer)), a nitride layer (for example, a silicon nitride (SiNₓ) layer), or an oxynitride layer (for example, a silicon oxynitride layer).

As some examples of the present invention, for example, the first passivation layer 214 and/or the second passivation layer 224 may be an oxide layer (for example, a silicon oxide layer or an aluminum oxide layer (AlOₓ layer)) of a single material, or may be a nitride layer (for example, a silicon nitride (SiNₓ) layer) of a single material, or may be an oxynitride layer (for example, a silicon oxynitride layer) of a single material, or may be a combination of an oxide layer (for example, a silicon oxide layer or an aluminum oxide layer (AlOₓ layer)) and a nitride layer (for example, a silicon nitride (SiNₓ) layer). It may be understood that specific structures of the first passivation layer 214 and/or the second passivation layer 224 include, but are not limited to, the several manners listed above. The first passivation layer 214 and/or the second passivation layer 224 may be correspondingly disposed according to actual application requirements, and are not specifically limited herein. The silicon oxide layer may be prepared according to an actual application requirement using chemical vapor deposition (CVD), plasma enhanced chemical vapor deposition (PECVD), or atomic layer deposition (ALD). This is not specifically limited herein. The nitride layer (for example, a silicon nitride (SiNₓ) layer) may be prepared according to an actual application requirement using chemical vapor deposition (CVD), plasma enhanced chemical vapor deposition (PECVD), low-pressure chemical vapor deposition (LPCVD), magnetron sputtering, or the like. If conditions permit, the SiNₓ layer is preferably prepared using chemical vapor deposition (CVD), plasma enhanced chemical vapor deposition (PECVD), low-pressure chemical vapor deposition (LPCVD). The aluminum oxide layer may be prepared according to an actual application requirement using atomic layer deposition (ALD), plasma enhanced ALD, pyrolytic deposition, remote PECVD, molecular beam epitaxy, Al deposition and oxidation. This is not specifically limited herein. A large amount of hydrogen is generated during thin-film deposition of silicon nitride and aluminum oxide, so that effective hydrogen passivation can be formed. In some embodiments of the present invention, a thickness of the first passivation layer 214 ranges from 60 nm to 80 nm, a thickness of the second passivation layer 224 ranges from 65 nm to 85 nm, and the thickness of the first passivation layer 214 is less than the thickness of the second passivation layer 224. For the specific backside structure B-TBC-1 of a TBC solar cell provided in this specific embodiment, the thickness of the first passivation layer 214 is 70 nm, and the thickness of the second passivation layer 224 is 75 nm.

Further, for the specific backside structure B-TBC-1 of a TBC solar cell provided in this specific embodiment, the depth of the isolation region 230 is 2.5 µm, and the width of the isolation region 230 is 40 µm. The selected base silicon wafer 1 has a resistivity of 6 ohm·cm, is an N-type monocrystalline silicon wafer, and has a thickness of 145 µm.

However, it should be noted that the base silicon wafer 1 can satisfy cell performance requirements of the present invention as long as the resistivity is greater than 10 ohm·cm. This is not limited and required herein. Various resistivities yield little difference in final cell performance.

### Embodiment 2

This embodiment provides a method for preparing the backside structure of a TBC solar cell according to Embodiment 1, specifically including the following steps:
Step S1: Polish a surface of a base silicon wafer.

In some embodiments of the present invention, a silicon wafer may be polished using an alkali solution to remove a damage layer, thereby forming a flat planar structure having a textured pattern. The textured pattern includes any one or two or three topographies of a pyramid structure, an inverted pyramid structure, or a truncated pyramid structure. In terms of dimension, a depth of the textured pattern is greater than 20 µm, and preferably, the depth ranges from 25 µm to 30 µm. However, it should be noted that apart from using the alkali solution, the operation in this step may actually be performed in any existing manner, and various methods yield little difference in technical effects.

Further, for the specific backside structure B-TBC-1 of a TBC solar cell provided in Embodiment 1, in this embodiment, a flat planar structure is formed while the damage layer on the surface is removed using a reaction between the KOH (potassium hydroxide) alkali solution and the base silicon wafer 1. The textured pattern of the planar structure is a truncated pyramid structure. In terms of dimension, a depth of a truncated pyramid ranges from 25 µm to 30 µm.

Step S2: First deposit a tunneling oxide layer and then deposit a polysilicon layer on the processed surface in step S1.

The depositing a polysilicon layer includes stage I and stage II, a deposition temperature in stage I is greater than a deposition temperature in stage II, and/or a deposition pressure in stage I is less than a deposition pressure in stage II.

In some embodiments of the present invention, the tunneling oxide layer (SiO₂) and the polysilicon layer (P-Poly) are deposited on a side of the backside 200 of the polished base silicon wafer 1 using LPCVD equipment. A thickness of the tunneling oxide layer ranges from 0.5 nm to 2.5 nm, a deposition temperature of the tunneling oxide layer ranges from 590°C to 650°C, a thickness of the polysilicon layer ranges from 50 nm to 400 nm, a deposition temperature of the polysilicon layer ranges from 550°C to 600°C, and a deposition pressure of the polysilicon layer ranges from 150 mTorr to 400 mTorr.

Based on this, in some embodiments of the present invention, the depositing a polysilicon layer on the surface includes stage I and stage II. The deposition temperature in stage I ranges from 580°C to 600°C. The deposition temperature in stage II ranges from 550°C to 580°C. In addition, the deposition pressures in stage I and stage II are any constant pressures selected from 150 mTorr to 220 mTorr. In some preferred embodiments, during the deposition in stage II, the deposition temperature uniformly decreases from 580°C to 550°C.

In some other embodiments of the present invention, the depositing a polysilicon layer on the surface includes stage I and stage II. The deposition pressure in stage I ranges from 150 mTorr to 220 mTorr. The deposition pressure in stage II ranges from 220 mTorr to 300 mTorr. In addition, the deposition temperatures in stage I and stage II are any constant temperatures selected from 550°C to 600°C. In some preferred embodiments, during the deposition in stage II, the deposition pressure uniformly increases from 220 mTorr to 300 mTorr.

In some other embodiments of the present invention, the depositing a polysilicon layer on the surface includes stage I and stage II;
the deposition temperature in stage I ranges from 580°C to 600°C; and simultaneously, the deposition pressure in stage I is any constant pressure selected from 150 mTorr to 220 mTorr; and
the deposition temperature in stage II ranges from 550°C to 580°C; and simultaneously, the deposition pressure in stage II ranges from 220 mTorr to 300 mTorr.

In some preferred embodiments, during the deposition in stage II, the deposition temperature uniformly decreases from 580°C to 550°C.

In some other preferred embodiments, during the deposition in stage II, the deposition pressure uniformly increases from 220 mTorr to 300 mTorr.

In some other preferred embodiments, during the deposition in stage II, the deposition temperature uniformly decreases from 580°C to 550°C; and simultaneously, during the deposition in stage II, the deposition pressure uniformly increases from 220 mTorr to 300 mTorr.

Further, for the specific backside structure B-TBC-1 of a TBC solar cell provided in Embodiment 1, in this embodiment, the depositing a polysilicon layer on the surface includes stage I and stage II. The deposition temperature in stage I is 595°C, and the deposition thickness is the same as the thickness of the high-concentration doped region 212a of B-TBC-1 provided in the foregoing Embodiment 1. The deposition temperature in stage II ranges from 550°C to 580°C, and the deposition thickness is the same as the thickness of the low-concentration doped region 212b of B-TBC-1 provided in the foregoing Embodiment 1. During the deposition in stage II, the deposition temperature uniformly decreases from 580°C to 550°C. In addition, the pressures in stage I and stage II are both a constant pressure of 250 mTorr.

Step S3: Perform doping using thermal diffusion to form a first doped polysilicon layer with a doped oxide layer.

In some other embodiments of the present invention, a P-type doped region with BSG of a specific thickness is formed through doping using thermal diffusion. A diffusion source is BCl₃ (boron chloride). A thickness of BSG ranges from 40 nm to 60 nm. After the diffusion, the doping concentration in the polysilicon layer in stage I ranges from 5E19 atoms/cm³ to 1E20 atoms/cm³. In a direction A (toward the base silicon wafer) shown in FIG. 3, the doping concentration in the polysilicon layer in stage II increases from N1 to N2 along a thickness, the doping concentration N1 ranges from 1E19 atoms/cm³ to 4E19 atoms/cm³, and the doping concentration N2 does not exceed the doping concentration in the polysilicon layer in stage I. Preferably, the doping concentration N2 and the doping concentration in the polysilicon layer in stage I are the same, ranging from 4.5E19 atoms/cm³ to 1E20 atoms/cm³.

Further, for the specific backside structure B-TBC-1 of a TBC solar cell provided in Embodiment 1, in this embodiment, a P-type doped region with BSG of a thickness being 50 nm is formed through doping using thermal diffusion. The diffusion source is BCl₃. After the diffusion, the thickness and the doping concentration in the polysilicon layer in stage I are the same as the thickness and the doping concentration of the high-concentration doped region 212a of B-TBC-1 provided in the foregoing Embodiment 1. In the direction A (toward the base silicon wafer) shown in FIG. 3, the thickness of the polysilicon layer in stage II is the same as the thickness of the low-concentration doped region 212b of B-TBC-1 provided in the foregoing Embodiment 1, and the doping concentration in the polysilicon layer in stage II increases from N1 to N2 along the thickness. The doping concentration N1 is the same as the doping concentration N1 in the low-concentration doped region 212b of B-TBC-1 provided in the foregoing Embodiment 1, and the doping concentration N2 is the same as the doping concentration in the high-concentration doped region 212a of B-TBC-1 provided in the foregoing Embodiment 1.

Step S4: Remove BSG in a specific region based on a specified pattern using laser processing or paste etching to expose the polysilicon layer.

Step S5: Perform alkaline polishing to remove the exposed polysilicon layer in step S4.

In some other embodiments of the present invention, the alkaline polishing is performed to remove the exposed polysilicon layer in step S4 to form a polished topography, and a region from which BSG is not removed is kept to form a height difference (GAP), GAP ranges from 0.1 µm to 0.3 µm, and the remaining thickness of BSG in the region with BSG unremoved ranges from 10 nm to 30 nm.

Further, for the specific backside structure B-TBC-1 of a TBC solar cell provided in Embodiment 1, an average height difference (GAP) formed in this embodiment is 0.15 µm, and the remaining average thickness of BSG in the region with BSG unremoved is 20 nm.

Step S6: Deposit a tunneling oxide layer and a polysilicon layer on a surface of the processed specific region in step S5.

In some other embodiments of the present invention, the tunneling oxide layer (SiO₂) and the polysilicon layer are deposited using LPCVD equipment on the backside 200 of the processed base silicon wafer in step S5. A thickness of the tunneling oxide layer ranges from 0.5 nm to 2.5 nm, and a deposition temperature of the tunneling oxide layer ranges from 590°C to 650°C. A thickness of the polysilicon layer ranges from 30 nm to 300 nm, and a deposition temperature of the polysilicon layer ranges from 590°C to 630°C.

Further, for the specific backside structure B-TBC-1 of a TBC solar cell provided in Embodiment 1, the deposition temperatures of the tunneling oxide layer and the polysilicon layer that are deposited using LPCVD equipment on the backside 200 of the processed base silicon wafer in step S5 are 610°C.

Step S7: Perform doping using thermal diffusion to form a second doped polysilicon layer with a doped oxide layer in the specific region.

In some other embodiments of the present invention, the processed base silicon wafer 1 in step S6 is placed in a diffusion furnace to implement N-type doping. A diffusion source is POCl₃ (phosphorus oxychloride). After diffusion, the doped oxide layer having a thickness ranging from 40 nm to 60 nm is formed, and the second doped polysilicon layer having a thickness ranging from 30 nm to 300 nm and a doping concentration ranging from 1E20 atoms/cm³ to 1E21 atoms/cm³ is formed.

Further, for the specific backside structure B-TBC-1 of a TBC solar cell provided in Embodiment 1, the processed base silicon wafer 1 in step S6 is placed in a diffusion furnace to implement N-type doping. A diffusion source is POCl₃. After diffusion, the doped oxide layer having a thickness of 55 nm is formed, and the second doped polysilicon layer having a thickness and a doping concentration the same as the thickness and the doping concentration of the second doped polysilicon layer 222 of B-TBC-1 provided in the foregoing Embodiment 1 is formed.

Step S8: Remove PSG in regions of the first doped polysilicon layer and the second doped polysilicon layer based on a specified pattern using laser processing or paste etching.

Step S9: Remove second doped polysilicon layer in a region in which the first doped polysilicon layer 212 is located on a backside using inline acid etching, and form a groove between the region in which the first doped polysilicon layer 212 is located and the region in which the second doped polysilicon layer 222 is located.

In some other embodiments of the present invention, the backside 200 of the base silicon wafer is removed using inline acid etching the second doped polysilicon layer 222 of the first emitter region 210 is also synchronously removed, and a groove is formed between the first emitter region 210 and the second emitter region 220.

Step S10: Deposit a passivation layer on the backside of the base silicon wafer.

Finally, for the specific backside structure B-TBC-1 of a TBC solar cell provided in Embodiment 1, an isolation region 230 is formed at the groove.

In some other embodiments of the present invention, the first passivation layer 214 having a thickness ranging from 40 nm to 80 nm and the second passivation layer 224 having a thickness ranging from 40 nm to 80 nm are respectively formed on the surfaces of polysilicon layers on two sides of the groove on the backside 200 of the base silicon wafer using ALD or PECVD equipment.

Step S11: Perform printing and sintering on the backside 200 of the base silicon wafer to form a first metal electrode 213 and a second metal electrode 223 that are located in the first emitter region 210 and the second emitter region 220, respectively.

### Comparative Example 1

This comparative example provides a backside structure (B-TBC-D1) of a TBC solar cell. The backside structure of a TBC solar cell is substantially the same as the backside structure (B-TBC-1) of a TBC solar cell in Embodiment 1. A difference lies only in that the first doped polysilicon layer 212 is no longer divided into the high-concentration doped region 212a and the low-concentration doped region 212b. A doping concentration in the first doped polysilicon layer 212 in the thickness D1 of the first doped polysilicon layer 212 is the same as the doping concentration in the high-concentration doped region 212a in Embodiment 1.

A method for preparing the backside structure (B-TBC-D1) of a TBC solar cell in this comparative example is substantially the same as that in Embodiment 2, and a difference lies only in "deposition of the polysilicon layer in step S2".

Deposition conditions (a temperature and a pressure) of the polysilicon layer in this comparative example are the same as those in stage I of step S2 in Embodiment 2, and deposition is performed until the thickness reaches D1 of the backside structure (B-TBC-1) of a TBC solar cell in Embodiment 1.

### Comparative Example 2

This comparative example provides a backside structure (B-TBC-D2) of a TBC solar cell. The backside structure of a TBC solar cell is substantially the same as the backside structure (B-TBC-1) of a TBC solar cell in Embodiment 1. A difference lies only in that the first doped polysilicon layer 212 is no longer divided into the high-concentration doped region 212a and the low-concentration doped region 212b. A doping concentration in the first doped polysilicon layer 212 in the thickness D1 of the first doped polysilicon layer 212 is the same as the doping concentration N1 in the low-concentration doped region 212b.

A method for preparing the backside structure (B-TBC-D1) of a TBC solar cell in this comparative example is substantially the same as that in Embodiment 2, and a difference lies only in "deposition of the polysilicon layer in step S2".

A deposition pressure of the polysilicon layer in this comparative example is the same as that in stage II of step S2 in Embodiment 2, a deposition temperature is a constant temperature of 550°C, and deposition is performed until the thickness reaches D1 of the backside structure (B-TBC-1) of a TBC solar cell in Embodiment 1.

FIG. 6 is doping curves in a first doped polysilicon layer (that is, P-type polysilicon) in Embodiment 1 and Comparative Examples 1 and 2 of the present invention.

### Comparative Example 3

This comparative example provides a backside structure (B-TBC-D3) of a TBC solar cell. The backside structure of a TBC solar cell is substantially the same as the backside structure (B-TBC-1) of a TBC solar cell in Embodiment 1. A difference lies only in that the first doped polysilicon layer 212 is no longer divided into the high-concentration doped region 212a and the low-concentration doped region 212b. A doping concentration in the first doped polysilicon layer 212 in the thickness of the first doped polysilicon layer 212 is higher than the doping concentration in the high-concentration doped region 212a, and is 7E19 atoms/cm³. In addition, the thickness of the first doped polysilicon layer 212 is no longer D1, but is the same as the thickness (D1-D2) of the high-concentration doped region 212a.

A method for preparing the backside structure (B-TBC-D1) of a TBC solar cell in this comparative example is substantially the same as that in Embodiment 2, and a difference lies only in "deposition of the polysilicon layer in step S2".

Deposition conditions (a temperature and a pressure) of the polysilicon layer in this comparative example are explored to be optimum values of a temperature of 595°C and a pressure of 230 mTorr, and deposition is performed until the thickness reaches a corresponding thickness.

### Comparative Example 4

This comparative example provides a backside structure (B-TBC-D4) of a TBC solar cell. The backside structure of a TBC solar cell is substantially the same as the backside structure (B-TBC-1) of a TBC solar cell in Embodiment 1. A difference lies only in that the doping concentration in the low-concentration doped region 212b of the first doped polysilicon layer 212 in the thickness of the low-concentration doped region 212b no longer changes, and is substantially the same concentration of 3E19 atoms/cm³.

### Embodiment 3

This embodiment provides a backside structure (B-TBC-3) of a TBC solar cell. The backside structure of a TBC solar cell is substantially the same as the backside structure (B-TBC-1) of a TBC solar cell in Embodiment 1. A difference lies only in that a thickness ratio of the first doped polysilicon layer 212 to the low-concentration doped region 212b of the first doped polysilicon layer 212 is D1/D2 = 1.5.

### Embodiment 4

This embodiment provides a backside structure (B-TBC-4) of a TBC solar cell. The backside structure of a TBC solar cell is substantially the same as the backside structure (B-TBC-1) of a TBC solar cell in Embodiment 1. A difference lies only in that a thickness ratio of the first doped polysilicon layer 212 to the low-concentration doped region 212b of the first doped polysilicon layer 212 is D1/D2 = 12.

### Embodiment 5

This embodiment provides a backside structure (B-TBC-5) of a TBC solar cell. The backside structure of a TBC solar cell is substantially the same as the backside structure (B-TBC-1) of a TBC solar cell in Embodiment 1. A difference lies only in a ratio of the doping concentration N1 to the doping concentration N2 in the low-concentration doped region 212b of the first doped polysilicon layer 212. In this embodiment, N2/N1 = 1 (N2/N1 ≥ 1.25 is no longer satisfied).

### Embodiment 6

This embodiment further provides a TBC solar cell. For ease of description, only a part related to the embodiments of the present invention is shown, referring to FIG. 2 to FIG. 4.

The TBC solar cell includes: a base silicon wafer 100;
the backside structure according to Embodiment 1 disposed on a backside 200 of the base silicon wafer; and
a third passivation layer 110 that is disposed on a front side 100 of the base silicon wafer, that has a thickness of 50 nm to 100 nm, and that has a reflectivity less than 2%. Further, for a specific TBC solar cell (TBC-1) provided in this embodiment, the thickness of the third passivation layer 110 is 75 nm. In principle, the composition and structure of the third passivation layer 110 may be the same as or different from those of the first passivation layer 214 (or the second passivation layer 224), and may be correspondingly adjusted as required. Specifically, in this embodiment, the composition and the structure of the third passivation layer 110 are identical with those of the first passivation layer 214 (or the second passivation layer 224). The preparation of the TBC solar cell in this embodiment is as follows:

The method for preparing a TBC solar cell specifically includes the following steps:
A1 to A8 and A11 are the same as steps S1 to S8 and S11 in Embodiment 2.

A9: Remove wrap-around depositions on the front side 100 of the base silicon wafer using inline acid etching, and then place the front side 100 of the base silicon wafer in a tank-type texturing tank to complete texturing, so that a textured surface of a pyramid topography is formed on the front side 100 of the base silicon wafer, and moreover, has a function the same as that in S9 of Embodiment 2.

A10: Deposit the first passivation layer 214 and the second passivation layer 224 on the backside of the base silicon wafer 1, and deposit the third passivation layer 110 on the front side of the base silicon wafer 1.

The third passivation layer 110 is formed on the front side of the base silicon wafer 100 through ALD and PECVD, and moreover, has a function the same as that in step S10 of Embodiment 2.

Based on the backside structure of a TBC solar cell in this embodiment and the foregoing Embodiment 1, a TBC solar cell (TBC-1) is prepared in this embodiment:
In addition, the following TBC solar cells are further prepared in this embodiment further based on the backside structures of a TBC solar cell in Comparative Examples 1 to 4 and Embodiments 3 to 5:
a TBC solar cell (TBC-D1) having the backside structure of a TBC solar cell in Comparative Example 1 as shown in FIG. 1;
a TBC solar cell (TBC-D2) having the backside structure of a TBC solar cell in Comparative Example 2;
a TBC solar cell (TBC-D3) having the backside structure of a TBC solar cell in Comparative Example 3;
a TBC solar cell (TBC-D4) having the backside structure of a TBC solar cell in Comparative Example 4;
a TBC solar cell (TBC-3) having the backside structure of a TBC solar cell in Embodiment 3;
a TBC solar cell (TBC-4) having the backside structure of a TBC solar cell in Embodiment 4; and
a TBC solar cell (TBC-5) having the backside structure of a TBC solar cell in Embodiment 5.

**Table 1. Table of performance and yield of the TBC solar cells**

| Solar cell | Eta (%) | Voc (mV) | Jsc (mA/cm²) | FF (%) | ρc (mΩ·cm²) | Yield (%) |
|---|---|---|---|---|---|---|
| TBC-1 | 26.62 | 744.6 | 41.95 | 85.23 | 0.35 | 96 |
| TBC-2 | 26.58 | 744.2 | 41.92 | 85.20 | 0.37 | 93 |
| TBC-3 | 26.47 | 742.5 | 41.91 | 85.06 | 0.58 | 94 |
| TBC-4 | 26.24 | 738.2 | 41.93 | 84.82 | 0.28 | 75 |
| TBC-5 | 26.22 | 737.6 | 41.93 | 84.78 | 0.31 | 70 |
| TBC-D1 | 26.38 | 742.1 | 41.92 | 84.81 | 0.35 | 60 |
| TBC-D2 | 26.40 | 741.8 | 41.92 | 84.91 | 0.85 | 90 |
| TBC-D3 | 26.31 | 737.8 | 41.94 | 85.05 | 0.42 | 48 |
| TBC-D4 | 26.52 | 743.5 | 41.93 | 85.08 | 0.40 | 92 |

Described above are merely exemplary embodiments of the present invention, and are not intended to limit the present invention.

## Claims

1. A backside structure of a TBC solar cell, wherein the backside structure comprises a first emitter region (210), an isolation region (230), and a second emitter region (220) that are located on the backside (200) of a base silicon wafer;
the first emitter region (210) comprises a first tunneling oxide layer (211), a first doped polysilicon layer (212), a passivation layer (214), and a first metal electrode (213) that are stacked on the backside (200) of the base silicon wafer, and the first metal electrode (213) is in contact with the first doped polysilicon layer (212) through the passivation layer (214);
the second emitter region (220) comprises a second tunneling oxide layer (221), a second doped polysilicon layer (222), a passivation layer, and a second metal electrode (223) that are stacked on the backside of the base silicon wafer (1), and the second metal electrode (223) is in contact with the second doped polysilicon layer (222) through the passivation layer (224);
the isolation region (230) is disposed between the first emitter region (210) and the second emitter region (220);
the first doped polysilicon layer (212) comprises a high-concentration doped region (212a) and a low-concentration doped region (212b);
the doping concentration in the low-concentration doped region (212b) increases from N1 to N2 in terms of thickness in the direction toward the base silicon wafer (1), and the highest doping concentration N2 in the low-concentration doped region (212b) does not exceed the doping concentration in the high-concentration doped region (212a);
the high-concentration doped region (212a) is located on the side close to the backside (200) of the base silicon wafer, and the first metal electrode (213) penetrates the low-concentration doped region (212b) to make contact with the high-concentration doped region (212a).

2. The backside structure of a TBC solar cell according to claim 1, wherein the doping concentration N1 in the low-concentration doped region (212b) ranges from 1E19 atoms/cm³ to 4E19 atoms/cm³, and the doping concentration N2 in the low-concentration doped region (212b) ranges from 5E19 atoms/cm³ to 1E20 atoms/cm³.

3. The backside structure of a TBC solar cell according to claim 2, wherein N2/N1 ≥ 1.25.

4. The backside structure of a TBC solar cell according to claim 2, wherein the doping concentration in the high-concentration doped region (212a) ranges from 5E19 atoms/cm³ to 1E20 atoms/cm³.

5. The backside structure of a TBC solar cell according to any one of claims 1 to 4, wherein the thickness of the first doped polysilicon layer (212) is D1, the thickness of the low-concentration doped region (212b) is D2, the thickness of the high-concentration doped region (212a) is D1-D2, and 2 < D1/D2 < 10.

6. The backside structure of a TBC solar cell according to claim 5, wherein the thickness of the first doped polysilicon layer (212) is D1, and 50 nm ≤ D1 ≤ 400 nm; and the thickness of the low-concentration doped region (212b) is D2, and 10 nm < D2 < 150 nm;
and/or the thickness of the second doped polysilicon layer (222) ranges from 30 nm to 300 nm, and the doping concentration in the second doped polysilicon layer (222) ranges from 1E20 atoms/cm³ to 1E21 atoms/cm³.

7. The backside structure of a TBC solar cell according to any one of claims 1 to 4 and claim 6, wherein the thickness of the first tunneling oxide layer (211) ranges from 0.5 nm to 2.5 nm; and/or
the thickness of the second tunneling oxide layer (221) ranges from 0.5 nm to 2.5 nm; and/or
the thickness of the passivation layer ranges from 40 nm to 80 nm.

8. The backside structure of a TBC solar cell according to any one of claims 1 to 4 and claim 6, wherein the depth of the isolation region (230) ranges from 0.05 µm to 3 µm.

9. A preparing method for the backside structure of a TBC solar cell, comprising:
polishing a surface of a base silicon wafer (1);
first depositing a tunneling oxide layer and then depositing a polysilicon layer on the polished surface, wherein
the depositing a polysilicon layer comprises stage I and stage II, the deposition temperature in stage I is greater than the deposition temperature in stage II, and/or
the deposition pressure in stage I is less than the deposition pressure in stage II;
performing doping using thermal diffusion to form a first doped polysilicon layer (212) with a doped oxide layer;
removing the doped oxide layer in a specific region using laser processing or etching to expose the polysilicon layer;
performing alkaline polishing to remove the exposed polysilicon layer;
depositing a tunneling oxide layer and a polysilicon layer on the surface of the specific region after the aforementioned alkali polishing treatment;
performing doping using thermal diffusion to form a second doped polysilicon layer (222) with a doped oxide layer in the specific region;
removing a doped oxide in a region of the first doped polysilicon layer (212) and a doped oxide in a region of the second doped polysilicon layer (222) using laser processing or etching;
removing second doped polysilicon layer (222) in the region in which the first doped polysilicon layer (212) is located on the backside (200) of the base silicon wafer, and forming a groove between the region where the first doped polysilicon layer (212) is located and a region where the second doped polysilicon layer (222) is located;
depositing a passivation layer on the backside of the base silicon wafer; and
performing printing and sintering on the backside (200) of the base silicon wafer to form a first metal electrode (213) and a second metal electrode (223).

10. The preparing method for the backside structure of a TBC solar cell according to claim 9, wherein, the depositing a polysilicon layer on the polished surface comprises stage I and stage II;
the deposition temperature in stage I ranges from 580°C to 600°C; and
the deposition temperature in stage II ranges from 550°C to 580°C;
and/or
the deposition pressure in stage I ranges from 150 mTorr to 250 mTorr; and
the deposition pressure in stage II ranges from 200 mTorr to 400 mTorr.

11. The preparing method for the backside structure of a TBC solar cell according to claim 9 or 10, wherein, during the deposition in stage I, the deposition temperature is kept constant; and
during the deposition in stage II, the deposition temperature gradually decreases from 580°C to 550°C;
and/or
during the deposition in stage I, the deposition pressure is kept constant; and
during the deposition in stage II, the deposition pressure is constant or gradually increases.

12. A TBC solar cell, comprising: a base silicon wafer (1);
a back contact structure disposed on the backside (200) of the base silicon wafer, wherein the back contact structure is the backside structure of a TBC solar cell according to any one of claims 1 to 8, or the back contact structure is prepared using the preparing method for the backside structure of a TBC solar cell according to any one of claims 9 to 11; and
a third passivation layer disposed on the front side of the base silicon wafer.

13. A preparing method for the TBC solar cell, comprising:
polishing a surface of a base silicon wafer;
first depositing a tunneling oxide layer and then depositing a polysilicon layer on the polished surface, wherein
the depositing a polysilicon layer comprises stage I and stage II, the deposition temperature in stage I is greater than the deposition temperature in stage II, and/or
the deposition pressure in stage I is less than the deposition pressure in stage II;
performing doping using thermal diffusion to form a first doped polysilicon layer (212) with a doped oxide layer;
removing the doped oxide layer in a specific region using laser processing or etching to expose the polysilicon layer;
performing alkaline polishing to remove the exposed polysilicon layer;
depositing a tunneling oxide layer and a polysilicon layer on the surface of the specific region after the aforementioned alkali polishing treatment;
performing doping using thermal diffusion to form a second doped polysilicon layer (222) with a doped oxide layer in the specific region;
removing a doped oxide in a region of the first doped polysilicon layer and a doped oxide in a region of the second doped polysilicon layer using laser processing or etching;
etching and texturing a front side of the base silicon wafer (1): removing second doped polysilicon layer (222) in the region in which the first doped polysilicon layer (212) is located on the backside (200) of the base silicon wafer, and forming a groove between the region where the first doped polysilicon layer (212) is located and a region where the second doped polysilicon layer (222) is located;
depositing a passivation layer on the backside of the base silicon wafer; and
performing printing and sintering on the backside of the base silicon wafer to form a first metal electrode (213) and a second metal electrode (223).

14. The preparing method for the TBC solar cell according to claim 13, wherein the depositing a polysilicon layer on the polished surface comprises stage I and stage II;
the deposition temperature in stage I ranges from 580°C to 600°C; and
the deposition temperature in stage II ranges from 550°C to 580°C;
and/or
the deposition pressure in stage I ranges from 150 mTorr to 250 mTorr; and
the deposition pressure in stage II ranges from 200 mTorr to 400 mTorr.

15. The preparing method for the TBC solar cell according to claim 13 or 14, wherein, during the deposition in stage I, the deposition temperature is kept constant; and
during the deposition in stage II, the deposition temperature gradually decreases from 580°C to 550°C;
and/or
during the deposition in stage I, the deposition pressure is kept constant; and
during the deposition in stage II, the deposition pressure is constant or gradually increases.
